# EUROPÄISCHE PATENTSCHRIFT

(11) **EP 1 110 237 B1**
(45) Veröffentlichungstag und Bekanntmachung des Hinweises auf die Patenterteilung: **03.03.2010**
(21) Anmeldenummer: 00951213.8
(22) Anmeldetag: 16.06.2000
(51) Int. Cl.: H01L 21/3065, H01J 37/32

(54) **VORRICHTUNG UND VERFAHREN ZUM HOCHRATENÄTZEN EINES SUBSTRATES MIT EINER PLASMAÄTZANLAGE UND VORRICHTUNG UND VERFAHREN ZUM ZÜNDEN EINES PLASMAS UND HOCHREGELN ODER PULSEN DER PLASMALEISTUNG**
DEVICE AND METHOD FOR THE HIGH-FREQUENCY ETCHING OF A SUBSTRATE USING A PLASMA ETCHING INSTALLATION AND DEVICE AND METHOD FOR IGNITING A PLASMA AND FOR PULSING THE PLASMA OUTPUT OR ADJUSTING THE SAME UPWARDS
DISPOSITIF ET PROCEDE DE GRAVURE HAUTE VITESSE D'UN SUBSTRAT AU MOYEN D'UNE INSTALLATION DE GRAVURE AU PLASMA, ET DISPOSITIF ET PROCEDE POUR ALLUMER UN PLASMA ET REGULER VERS LE HAUT OU PULSER LA PUISSANCE DU PLASMA

(30) Priorität: 18.06.1999 DE 19927806
(43) Veröffentlichungstag der Anmeldung: 27.06.2001
(73) Patentinhaber: ROBERT BOSCH GMBH, 70442 Stuttgart (DE)
(72) Erfinder: BECKER, Volker, D-76359 Marxzell (DE); LAERMER, Franz, D-70437 Stuttgart (DE); SCHILP, Andrea, D-73525 Schwaebisch Gmuend (DE); BECK, Thomas, D-71737 Kirchberg/Murr (DE)
(86) Internationale Anmeldenummer: PCT/DE2000/001906
(87) Internationale Veröffentlichungsnummer: WO 2000/079579

(56) Entgegenhaltungen:
- EP-A- 0 363 982
- EP-A- 0 822 582
- WO-A-00/62328
- PATENT ABSTRACTS OF JAPAN vol. 1996, no. 02, 29. Februar 1996 (1996-02-29) -& JP 07 288191 A (HITACHI LTD), 31. Oktober 1995 (1995-10-31)
- PATENT ABSTRACTS OF JAPAN vol. 1999, no. 04, 30. April 1999 (1999-04-30) -& JP 11 016892 A (NEC CORP), 22. Januar 1999 (1999-01-22) -& US 6 054 063 A (OHTAKE ET AL.) 25. April 2000 (2000-04-25)

## Beschreibung

Die Erfindung betrifft eine Vorrichtung und ein Verfahren zum insbesondere anisotropen Hochratenätzen eines Substrates mit einer Plasmaätzanlage, wobei periodisch variierende Plasmaleistungen von bis zu 5000 Watt erreicht werden können, sowie eine Vorrichtung und ein Verfahren zum Zünden eines Plasmas und zum Hochregeln oder Pulsen der Plasmaleistung, nach der Gattung der unabhängigen Ansprüche.

### Stand der Technik

Aus der DE 42 41 045 C1 ist ein Verfahren zum anisotropen Ätzen von Silizium mit hohen Ätzraten und hoher Maskenselektivität bekannt, wobei eine hochdichte Plasmaquelle mit vorzugsweiser induktiver Hochfrequenzanregung eingesetzt wird, um aus einem fluorliefernden Ätzgas Fluorradikale und aus einem teflonbildende Monomere liefernden Passiviergas (CF₂)ₓ - Radikale freizusetzen. Dabei werden Ätz- und Passiviergas alternierend eingesetzt, wobei während der Passivierschritte oder Polymerisationsschritte auf den Seitenwänden bereits geätzter Strukturen ein Seitenwandpolymerfilm aufgebaut wird, der in den an sich isotropen Ätzschritten mit Ionenunterstützung jedesmal teilweise wieder abgebaut und gleichzeitig der Siliziumstrukturgrund durch Fluorradikale geätzt wird. Dieser Prozeß benötigt eine hochdichte Plasmaquelle, die auch eine relativ hohe Dichte von Ionen (10¹⁰-10¹¹ cm⁻³) niedriger Energie generiert.

Eine für viele Applikationen erforderliche Steigerung der Ätzrate ist im allgemeinen zu erwarten, wenn die in das Plasma eingekoppelte Hochfrequenzleistung gesteigert wird.

Bei Verfahren nach Art der DE 42 41 045 C1 ist dies jedoch überraschenderweise nicht der Fall. Man beobachtet stattdessen, daß sich die Ätzrate in Silizium bei einer Leistungserhöhung der Plasmaquelle nur geringfügig erhöht, während gleichzeitig unerwünschte Profilabweichungen besonders im oberen Drittel der erzeugten Trenchgräben stark zunehmen, so daß Profileinschnitte, oder Hinterschneidungen des Maskenrands auftreten.

Diese Effekte stammen einerseits aus unerwünschten kapazitiven Einkopplungen aus Bereichen der induktiven Plasmaquelle, die sehr hohe hochfrequente Spannungen führen. Bei höheren Leistungen und Spannungen sind naturgemäß auch diese unerwünschten Störeffekte höher.

Insoweit die Plasmaquelle selbst betroffen ist, lassen sich die genannten Effekte durch fortgeschrittenere Speisekonzepte der Plasmaquelle und beispielsweise durch Einsatz einer speziellen Apertur, wie sie in der DE 197 34 278 C1 beschrieben sind, zumindest weitgehend beheben. Es verbleiben jedoch diejenigen Profilverschlechterungen, die prozeßbedingt sind und daher prozeßseitig angegangen werden müssen.

Während bei einfachen Plasmastrukturierungsprozessen eine Erhöhung der Plasmaleistung aufgrund der daraus resultierenden vermehrten Produktion von Ionen und Ätzspezies zur gewünschten Steigerung der Ätzrate führt, sind bei dem Verfahren nach Art der DE 42 41 045 C1 neben den Ätzschritten auch die Depositionsschritte zu berücksichtigen. Eine Erhöhung der Plasmaleistung in den Ätzschritten führt dabei nicht nur zur gewünschten vermehrten Produktion von Ätzspezies und Ionen, sondern verändert in charakteristischer Weise auch die Depositionsschritte.

Ein sehr wesentlicher Aspekt der DE 42 41 045 C1 ist der Seitenwandfilmtransportmechanismus, der während der an sich isotropen Ätzschritte dafür sorgt, daß der Seitenwandschutzfilm beim Weiterätzen mit in die Tiefe des Trenchgrabens bewegt wird und bereits dort für einen lokalen Kantenschutz sorgen kann. Während der Depositions- oder Polymerisationsschritte selbst ist ein solcher Transportmechanismus jedoch nur innerhalb gewisser Grenzen erwünscht. So soll insbesondere vermieden werden, daß bereits während der Depositionszyklen zuviel Seitenwandpolymer nach unten in die Trenchgräben getrieben wird und dann oben fehlt, d.h. der Seitenwandfilm wird dort zu dünn.

Bei einer Erhöhung der Plasmaleistung in den Ätz- und Depositionsschritten erfolgt nun beispielsweise bei einem Prozeß gemäß der DE 41 42 045 C1, an sich ungewollt, auch während der Depositionsschritte, in Konkurrenz zur Beschichtung der Seitenwände ein vermehrter Polymertransport von der Seitenwand in die Tiefe der Trenchgräben, da sich oberhalb einer gewissen Plasmaleistung die Depositionsrate nicht mehr wesentlich steigern läßt, sondern stattdessen vermehrt Ionen produziert werden, die auf das zu ätzende Substrat einfallen.

Dieser zunehmende Ionenfluß zum Substrat führt aufgrund des Plasmapotentials, das auch ohne eine zusätzlich angelegte Substratelektrodenspannung etwas oberhalb des Substratpotentials liegt, dazu, daß bereits während der Depositionsschritte ein zunehmender Teil des deponierten Filmmaterials in die Tiefe der Trenchgräben und zum Ätzgrund gedrückt wird. Insbesondere weist das Plasma gegenüber geerdeten Oberflächen und damit auch gegenüber einem Substrat auf der Substratelektrode ein Plasmapotential von einigen Volt bis zu einigen 10 Volt auf, was einer entsprechenden Ionenbeschleunigung zum Wafer hin gleichkommt. Eine erhöhte Ionendichte bedeutet daher auch eine vermehrte Ioneneinwirkung auf die Substratoberfläche und speziell auf die Trenchseitenwände, obwohl explizit keine Ionenbeschleunigungsspannung an die Substrate angelegt wird.

Infolge des erläuterten bei sehr hohen Plasmaleistungen bewirkten Polymerabtrags und -verschleppens in die Tiefe der Trenchgräben bereits während der Depositionsschritte, fehlt schließlich bei hohen Plasmaleistungen in den oberen Teilen der geätzten Trenchgräben das in den nachfolgenden Ätzschritten zum Seitenwandschutz benötigte Polymermaterial, was sich in den erwähnten Profilabweichungen etwa im oberen Drittel des Trenchprofils manifestiert. Zugleich stört das im Übermaß zum Ätzgrund transportierte Polymermaterial auch den Ätzabtrag in den nachfolgenden Ätzschritten und führt insgesamt zur beobachteten Sättigung der Ätzrate trotz weiterer Leistungserhöhung in der Quelle. Ein weiterer Effekt in diesem Zusammenhang ist die "Härtung" des abgeschiedenen Polymermaterials bei sehr hohen Leistungsdichten, d.h. ein gesteigerter Kohlenstoffanteil in derart verdichtetem Polymer, was den nachfolgenden Polymerabtrag erschwert und damit die Ätzraten reduziert.

In der EP 0822582 wird beim Ätzen mit einer höheren Leistung (coil power) gearbeitet als beim Depositionsschritt. Hier wird aber nur zwischen den beiden Leistungszuständen hin und her geschaltet. Eine angepasste Leistungsregelung wird weder erkannt noch erwähnt.

In der WO-A-00/62328 wird mit einem Wechsel der Gassorte und des Prozessdrucks gearbeitet. Ferner erfolgt dort eine Speicherung der beiden Positionen Ätzen und Deposition, sodass zwischen diesen umgeschaltet wird.

Es ist daher Aufgabe der vorliegenden Erfindung, eine Sättigung der Ätzrate trotz einer höheren, von der Plasmaquelle bereitgestellten Hochfrequenzleistung zu überwinden und somit die Ätzrate damit drastisch zu steigern. Es ist weiter Aufgabe der Erfindung, das Zünden und die Einkopplung von sehr hohen Hochfrequenzleistungen in eine insbesondere induktive Plasmaquelle stabil möglich zu machen.

### Vorteile der Erfindung

Die erfindungsgemäßen Vorrichtungen und die erfindungsgemäßen Verfahren mit den kennzeichnenden Merkmalen der unabhängigen Ansprüche haben gegenüber dem Stand der Technik den Vorteil, daß damit eine periodische Änderung der an einer Plasmaquelle anliegenden Hochfrequenzleistung ermöglicht wird, so daß beispielsweise alternierende Depositions- bzw. Polymerisations- und Ätzschritte sehr vorteilhaft mit unterschiedlich hohen Hochfrequenzleistungen betrieben werden können. Dabei wird sehr vorteilhaft während der Ätzschritte zumindest zeitweise eine jeweils höhere Hochfrequenzleistung an der Plasmaquelle angelegt, als während der Depositionsschritte.

Weiterhin lassen sich durch die erfindungsgemäße Vorrichtung zum Ätzen und das erfindungsgemäße Verfahren zum anisotropen Ätzen eines Substrates erheblich höhere Ätzraten erreichen, als mit bekannten Ätzverfahren oder Ätzvorrichtungen. Dabei wird zusätzlich die bisher im Stand der Technik bestehende Schwierigkeit überwunden, daß trotz einer kontinuierlichen Erhöhung der Plasmaleistung eine Sättigung der Ätzrate bei anisotropen Ätzverfahren eintritt, bei denen abwechselnd Depositionschritte und Ätzschritte eingesetzt werden.

Weiterhin ist es sehr vorteilhaft, daß mit der erfindungsgemäßen Vorrichtung und dem damit durchgeführten Verfahren zum Zünden und Hochregeln eines Plasmas die Einkoppelung von sehr hohen Hochfrequenzleistungen in eine insbesondere induktive Plasmaquelle überhaupt erst stabil möglich wird.

Vorteilhafte Weiterbildungen der Erfindung ergeben sich aus den in den Unteransprüchen genannten Maßnahmen.

So kann mit dem erfindungsgemäßen Verfahren das Verfahren gemäß der DE 42 41 045 C1 sehr vorteilhaft durch Anlegen einer niedrigen Plasmaleistung während der Depositionsschritte und durch Anlegen einer sehr hohen Plasmaleistung während der Ätzschritte erheblich verbessert werden, wobei extrem hohen Ätzraten, beispielsweise in Silizium, unter Beibehaltung der aus DE 42 41 045 C1 bekannten Vorteile erzielt werden. Insbesondere bleiben bei dem erfindungsgemäßen Ätzverfahren die Depositionsschritte sehr vorteilhaft nahezu unverändert. Die Ätzschritte werden weiter vorteilhaft mit sehr hohen Plasmaleistungen von bis zu 5000 Watt bei vorzugsweise erhöhtem SF₆/O₂-Fluß und vorzugsweise erhöhtem Prozeßdruck betrieben.

Daneben wird durch das erfindungsgemäße Zurückschalten der Hochfrequenzleistung während der Polymerisationsschritte die Uniformität des Ätzprozesses signifikant verbessert, so daß die Substratmitte und der Substratrand nahezu identische Ätzraten aufweisen. Dies gilt insbesondere, wenn das erfindungsgemäße Verfahren zum Hochratenätzen mit einer Aperturvorrichtung in der Plasmaätzanlage kombiniert wird, wie sie aus DE 197 34 278 bekannt ist. Eine ganz besonders vorteilhafte Variante des erfindungsgemäßen Verfahrens hinsichtlich der Uniformität der Ätzung über einen Wafer ergibt sich dann, wenn eine Plasmaätzanlage wie sie beispielsweise aus DE 197 34 278 bekannt ist, weiter mit einer symmetrisch gespeisten Plasmaquelle betrieben wird, wie sie in der Anmeldung DE 199 00 179 vorgeschlagen wurde.

Weiterhin wird es mit der erfindungsgemäßen Vorrichtung zum Ätzen eines Substrates sehr vorteilhaft möglich, auch sehr hohe Hochfrequenzleistungen von bis zu 5000 Watt in insbesondere induktive Plasmaquellen stabil einzukoppeln. Dazu ist vorteilhaft ein zweites Mittel, insbesondere ein automatisierter Impedanztransformator vorgesehen, dessen Regelung entsprechend der Variation der Hochfrequenzleistung der Plasmaquelle erfolgt. Die geschwindigkeitsangepaßte Leistungsvariation der Plasmaquelle bzw. des diese speisenden Hochfrequenzgenerators wird überdies gleichzeitig vorteilhaft über einen Rampengenerator erzielt.

Die Regelung der Plasmaleistung mit einem Hochfrequenzgenerator und einem damit in Verbindung stehenden Rampengenerator sowie einem Impedanztransformator zur insbesondere fortwährenden und automatisierten Impedanzanpassung eignet sich dabei sehr vorteilhaft sowohl zum Zünden und zum Hochfahren eines Plasmas bis zu höchsten Leistungswerten, als auch für das erfindungsgemäße Alternieren der Leistungsparameter an der Plasmaquelle zwischen Ätz- und Depositionsschritten.

Die vermehrte Bildung von Ätzspezies durch eine höhere Plasmaleistung kann vorteilhaft weiter dadurch gefördert werden, daß simultan mit der Leistungserhöhung auch der Fluß des fluorliefernden Ätzgases, beispielsweise SF₆ erhöht wird. Zur Vermeidung von Schwefelausscheidungen im Abgasbereich der Ätzanlage ist dabei vorteilhaft entsprechend auch der Sauerstoffanteil einzustellen. Eine weitere vorteilhafte Möglichkeit zur Steigerung der Produktion von Fluorradikalen parallel zur Leistungserhöhung in den Ätzschritten ist die Erhöhung des Prozeßdrucks. Dadurch werden im Ätzplasma vorteilhaft vermehrt Fluorradikale anstelle von zusätzlichen Ionen produziert und somit das Verhältnis der Zahl der Fluorradikale zur Ionendichte erhöht. Das Überschreiten einer gewissen Ionendichte bei sehr hohen Plasmaleitungen ist nachteilig.

Im übrigen wird während der Deposition- oder Polymerisationsschritte vorteilhaft keine Leistungserhöhung auf beispielsweise mehr als 1500 Watt durchgeführt. Da die Depositionsrate auf dem Substrat bereits bei relativ kleiner Leistung von 400 Watt bis 800 Watt ausreicht, würde eine Leistungssteigerung der Plasmaquelle in den Depositionsschritten bei sonst unveränderten Plasmaätzparametern ohnehin nur wenige zusätzliche Depositionsspezies liefern bzw. das abgeschiedene Polymer zu stark verdichten und zu einer Kohlenstoffanreicherung im Polymer führen. Durch die Beibehaltung der ursprünglichen, niedrigen Leistung im Depositionsprozeß von bis zu 1500 Watt wird weiter gleichzeitig vorteilhaft vermieden, daß die Ionendichte und damit die Ioneneinwirkung auf das Substrat während der Depositionsschritte erhöht wird. Damit treten die erläuterten schädlichen Folgen einer erhöhten Ionendichte während der Depositionsschritte nicht auf.

### Zeichnung

Die Erfindung wird anhand der Zeichnung und in der nachfolgenden Beschreibung näher erläutert. Die Figur 1 zeigt eine Plasmaätzanlage mit Anbauteilen, Figur 2 einen ersten, in einem analogen Rampengenerator eingesetzten RC-Kreis, Figur 3 einen zweiten RC-Kreis mit einer Diode und Figur 4 einen dritten RC-Kreis mit zwei Dioden.

### Ausführungsbeispiele

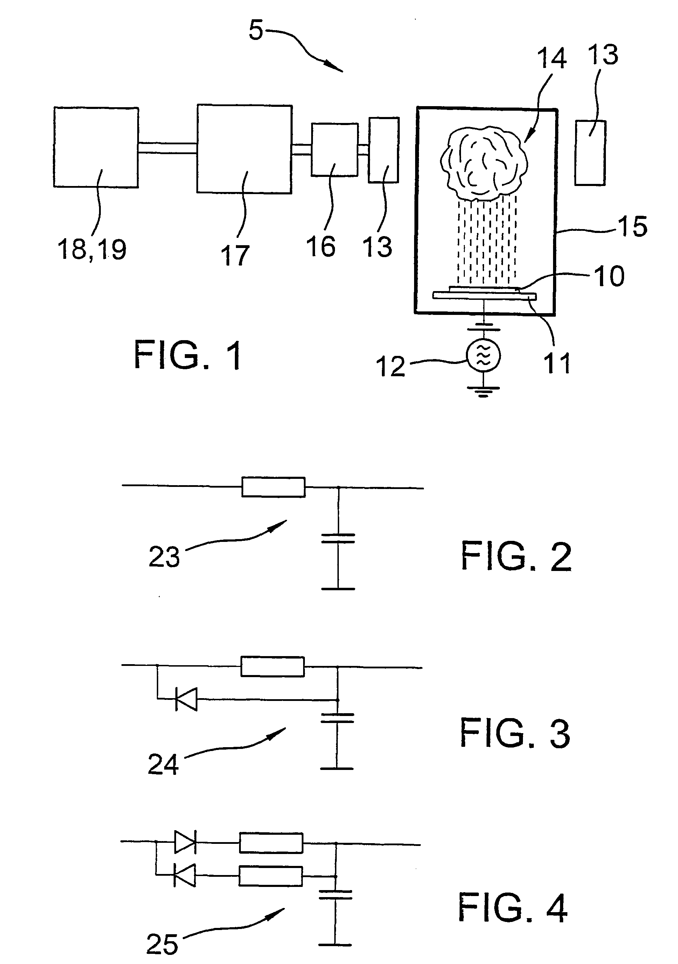

Die Figur 1 zeigt eine Plasmaätzanlage 5 mit einem Substrat 10, insbesondere einem strukturierten Siliziumwafer, der in einem anisotropen Plasmaätzverfahren mit Trenchgräben versehen werden soll und einer Substratelektrode 11, an die über einen Substratspannungsgenerator 12 eine hochfrequente Wechselspannung an der Substratelektrode 11 und darüber auch an dem Substrat 10 anliegt. Weiter ist eine Plasmaquelle 13 in Form einer an sich bekannten induktiven Plasmaquelle (ICP-Spule) vorgesehen, die in einem Reaktor 15 mit einem eingeleiteten Reaktivgasgemisch ein Plasma 14 erzeugt. Dazu wird über einen Hochfrequenzgenerator 17 ein hochfrequentes elektromagnetisches Wechselfeld generiert, dem das Reaktivgasgemisch ausgesetzt ist. Eine derartige Anordnung ist beispielsweise aus DE 197 34 278 C1 bekannt. Weiter ist in Figur 1 vorgesehen, daß der Hochfrequenzgenerator 17 mit einem Bauteil 18 in Verbindung steht, in das ein Rampengenerator 19 integriert ist, und daß der Hochfrequenzgenerator 17 und die Plasmaquelle 13 mit einem aus dem Stand der Technik bekannten Impedanztransformator 16 ("Matchbox") in Verbindung steht. Die Funktion und der Aufbau einer derartigen "Matchbox" ist an sich bekannt. Eine besonders vorteilhafte Ausführung der "Matchbox" in Verbindung mit einer induktiven Plasmaquelle mit balancierter Spuleneinspeisung wird in der unveröffentlichten Anmeldung DE 199 00 179.5 beschrieben.

Mit der Plasmaätzanlage 5 wird nun beispielsweise ein anisotroper Ätzprozeß mit alternierenden Ätz- und Depositionsschritten oder Polymerisationsschritten durchgeführt, wie er beispielsweise in DE 197 34 278 C1 oder insbesondere in DE 42 41 045 C1 beschrieben ist, wobei die an der Plasmaquelle 13 anliegende Hochfrequenzleistung periodisch verändert wird.

Dazu werden zunächst während der Depositionsschritte Hochfrequenzleistungen von 400 Watt bis maximal 1500 Watt, vorzugsweise von 600 Watt bis 800 Watt an die induktive Plasmaquelle 13 angelegt. Der Prozeßdruck liegt dabei zwischen 5 mTorr bis 100 mTorr, beispielsweise bei 20 mTorr.

Der Gasfluß für des im erläuterten Beispiel als Passiviergas verwendeten Octafluorcyclobutan (C₄F₈) oder Hexafluorpropen (C₃F₆) beträgt 30 sccm bis 200 sccm, vorzugsweise 100 sccm. Die Zeitdauer eines Depositionsschritts beträgt 1 Sekunde bis 1 Minute, beispielsweise 5 Sekunden.

Während der den Depositionsschritten nachfolgenden Ätzschritten werden Hochfrequenzleistungen von 600 Watt bis 5000 Watt, vorzugsweise von 3000 Watt, an die induktive Plasmaquelle 13 angelegt. Der Prozeßdruck liegt dabei zwischen 5 mTorr und 100 mTorr, beispielsweise bei 30 mTorr oder 50 mTorr, und ist bevorzugt gegenüber dem Prozeßdruck während der Depositonsschritte erhöht. In dieser Beschreibung, 1 Torr entspricht 133 Pa. Die eingesetzten Gasflüsse betragen im Fall des im erläuterten Beispiels verwendeten Ätzgases SF₆ 100 sccm bis 500 sccm, vorzugsweise 200 sccm bis 300 sccm, wobei dem Ätzgas SF₆ zur Vermeidung von Schwefelausscheidungen im Abgasbereich der Plasmaätzanlage 5 in einem Anteil von 10 bis 20 %, vorzugsweise 15 %, in an sich bekannter Weise Sauerstoff zugesetzt ist.

Weiter wird während der Ätzschritte zur Beschleunigung von im Plasma 14 erzeugten Ionen zum Substrat 10 an die Substratelektrode 11 eine Hochfrequenzleistung von 1 Watt bis 50 Watt angelegt. Diese beträgt im erläuterten Beispiel im Fall eines üblichen 6" 15cm--Siliziumwafers als Substrat 10 8 Watt. Entsprechend der jeweiligen Hochfrequenzleistung liegt weiter eine Ionenbeschleunigungsspannung von 1 V bis 50 V, beispielsweise 15 V an der Substratelektrode 11 an. Die Dauer eines Ätzschrittes beträgt ca. 3 Sekunden bis zu 2 Minuten. Im erläuterten Beispiel ist sie bei ca. 10 Sekunden.

Das Anlegen von sehr hohen Leistungen von bis zu 5000 Watt an die induktive Plasmaquelle 13 ist technisch sehr problematisch, da sich die Plasmaimpedanz in dem Maße verändert, wie die Leistung an der Plasmaquelle 13 gesteigert wird. Dies liegt daran, daß mit wachsender Plasmaleistung, also wachsender Erregung des Plasmas 14, eine wachsende Elektronen- und Ionendichte im Plasma 14 produziert wird. Mit der höheren Elektronen- und Ionendichte wird das Plasma 14 aber aus der Sicht der Plasmaquelle 13 zunehmend "niederohmiger", d.h. man nähert sich mehr und mehr dem bei hochdichten Plasmen gegebenen Idealzustand, dem "Kurzschlußfall", an. Dies bedeutet gleichzeitig, daß sich die Anpassungsbedingungen der induktiven Plasmaquelle 13 an den Hochfrequenzgenerator 17, der üblicherweise eine feste Ausgangsimpedanz von meist 50 Ω aufweist, verändert, und zwar dynamisch mit wachsender Leistung. Es ist daher eine Anpassung der Ausgangsimpedanz des Hochfrequenzgenerators 17 an die Impedanz der induktiven Plasmaquelle 13 erforderlich, welche wesentlich von der produzierten Ladungsträgerdichte im Plasma 14 abhängt.

Dazu ist im erläuterten Beispiel der Impedanztransformator 16 ("Matchbox") vorgesehen. Dieser Impedanztransformator 16 stellt üblicherweise durch automatische und kontinuierliche oder schrittweise Variation zweier Drehkondensatoren, die einen kapazitiven Transformator (Spannungsteiler) bilden, sicher, daß das Plasma 14 bzw. die Plasmaquelle 13 hinsichtlich ihrer Impedanz stets optimal an den Hochfrequenzgenerator 17 und dessen Hochfrequenzleistung angepaßt ist. Stimmt diese Anpassung nicht, treten reflektierte Leistungen bis zu 100 % der zugeführten Hochfrequenzleistung auf, die in den Hochfrequenzgenerator 17 zurücklaufen und dort üblicherweise zu einer Rückregelung der Vorwärtsleistung führen, um eine Zerstörung der Generatorendstufe zu verhindern. Bei den im erläuterten Beispiel eingesetzten Plasmaleistungen von bis zu 5000 Watt erfolgt diese Impedanzanpassung notwendigerweise dynamisch.

So wird zum Zünden des Plasmas 14 der Impedanztransformator zunächst in eine sogenannte "Preset"-Position gefahren, die bis zu einer gewissen, niedrigen Plasmaleistung der optimalen "Brennposition" des Impedanztransformators 16, d.h. der Position des Impedanztransformators 16 im Zustand -"Plasma an, geringe Leistung", entspricht. Die Automatik des Impedanztransformators 16 muß in diesem Fall nur eine Feinregelung übernehmen, um kleine Toleranzen der Plasmaimpedanz auszugleichen. Steigt die Plasmaleistung im weiteren dann aber auf Werte von beispielsweise mehr als 1000 Watt an, wie sie im erläuterten Beispiel während der Ätzschritte oder beim Hochregeln der Plasmaleistung nach dem Zünden eingesetzt werden, ändert sich die Plasmaimpedanz signifikant. So ist beispielsweise bei 3000 Watt eingekoppelter Hochfrequenzleistung an der induktiven Plasmaquelle 13 die Einstellung des Impedanztransformators 16 signifikant verschieden von der Zündposition bzw. der Position mit niedriger Plasmaleistung.

Entsprechendes gilt, wenn die Plasmaleistung, wie im vorliegenden Beispiel beim Übergang von einem Depositionsschritt zu einem Ätzschritt, von einem niedrigeren zu einem deutlich höheren Wert umgeschaltet wird. Der Leistungssprung zieht entsprechenden Korrekturbedarf am Impedanztransformator 16 nach sich. Erfolgt diese Korrektur nicht schnell genug, kommt es generatorseitig zur schlagartigen Rücknahme der Vorwärtsleistung durch entsprechende Schutzschaltungen und infolgedessen zum zeitweiligen Erlöschen oder fortwährenden Blinken des Plasmas 14.

Die erläuterten Schwierigkeiten beim Zünden und Hochregeln eines Plasmas 14 im Fall von Plasmaleistungen zwischen 800 Watt und 5000 Watt, sowie das periodische Umschalten der Plasmaleistung, beispielsweise zwischen Depositionsschritten und Ätzschritten werden in bevorzugter Ausgestaltung der Erfindung im erläuterten Beispiel dadurch gelöst, daß die Leistungserhöhung des Hochfrequenzgenerators 17 "adiabatisch" erfolgt, das heißt kontinuierlich oder schrittweise mit einer Anstiegsgeschwindigkeit, die durch den Impedanztransformator 16 dynamisch ausgeregelt werden kann. Im erläuterten Beispiel heißt das, daß die Plasmaleistung beispielsweise beim Übergang von einem Depositionsschritt zu einem Ätzschritt verlangsamt erhöht wird, während sich gleichzeitig der Impedanztransformator 16 kontinuierlich an die sich verändernden Impedanzverhältnisse aufgrund der sich verändernden Plasmabedingungen anpaßt bzw. diese ausregelt.

Im konkreten Fall der Plasmazündung stellt sich dies folgendermaßen dar: Der Impedanztransformator 16 steht in der vorgewählten Zündposition und der Hochfrequenzgenerator 17 beginnt seine Ausgangsleistung kontinuierlich oder schrittweise in kleinen Schritten von einem vorgegebenen Startwert auf einen Zielwert hochzuregeln. Nun wird bei einer gewissen Leistung, beispielsweise 400 Watt das Plasma 14 zünden, so daß an der Plasmaquelle 13 eine definierte Impedanz vorliegt. Während der Hochfrequenzgenerator 17 seine Ausgangsleistung dann weiter steigert, werden im Plasma 14 mehr und mehr Ladungsträger produziert und damit die Plasma- bzw. Quellenimpedanz verändert. Der Impedanztransformator 16 trägt diesen Veränderungen dadurch Rechnung, daß er kontinuierlich und automatisch die korrekte Impedanztransformation, beispielsweise in an sich bekannter Weise durch Verstellen von Drehkondensatoren, sicherstellt. In dem Maße, wie die Generatorausgangsleistung wächst, paßt der Impedanztransformator 16 seine Einstellung zumindest zeitweilig also den dadurch bewirkten Plasmabedingungen automatisch und möglichst gleichzeitig an. Auf diese Weise können daher auch Plasmaleistungen von mehreren kWatt, insbesondere bis zu 5000 Watt, stabil in das Plasma 14 eingekoppelt werden.

Typische Werte für den Startwert liegen im erläuterten Beispiel bei ca. 0 bis 400 Watt, während der Zielwert üblicherweise 800 Watt bis 5000 Watt beträgt. Die erforderliche Zeit für die Erhöhung der Leistung zwischen Start- und Zielwert liegt typischerweise bei 0,2 sec bis 5 sec, insbesondere 0,5 sec bis 2 sec.

Wesentlich ist im erläuterten Beispiel, daß zumindest bei Leistungsanstiegen keine sprunghaften Änderungen der Leistung des Hochspannungsgenerators 17 auftreten, die von dem Impedanztransformator 16 nicht ausgeregelt werden können, sondern möglichst alle Leistungsänderungen der Regelgeschwindigkeit des Impedanztransformators 16 angepaßt sind.

Dies gilt insbesondere auch für das erfindungsgemäße Alternieren der Plasmaleistung von einem niedrigeren Wert während der Depositionsschritte zu einem sehr hohen Wert, vorzugsweise im kWatt-Bereich, während der Ätzschritte. Der Depositionsschritt ist dabei mit seiner relativ niedrigen Leistung zunächst unkritisch. Erfolgt nun der Wechsel zum Ätzschritt, wird der Generator seine Ausgangsleistung langsam hochregeln, bis nach beispielsweise 2 Sekunden die volle, im Ätzschritt gewünschte Generatorleistung, an der Plasmaquelle 13 anliegt. Bei einer derartigen Anstiegsgeschwindigkeit sind übliche Impedanztransformatoren problemlos in der Lage, die Einstellung entsprechend nachzuregeln.

Beim Wechsel in den Depositionsschritt kann man die Plasmaleistung auf den niedrigeren Wert, der in den Depositionsschritten gewünscht ist, entweder schlagartig oder bevorzugt ebenfalls "adiabatisch", d.h. verlangsamt und der Regelgeschwindigkeit des Impedanztransformators 16 angepaßt, auf den niedrigeren Leistungswert zurückfahren. Da die Leistung in den Depositionsschritten unkritisch niedrig ist, stehen hier aber beide Optionen offen.

Die "adiabatische" Regelung der Leistung des Hochfrequenzgenerators 17 kann im erläuterten Beispiel entweder schrittweise in kleinen Schritten oder kontinuierlich erfolgen. Dazu wird beispielsweise in dem Bauteil 18 softwaregesteuert in an sich bekannter Weise ein digitaler Rampengenerator einprogrammiert, oder es wird ein ebenfalls an sich bekannter analoger Rampengenerator 19 in das Bauteil 18 integriert, der somit zwischen dem Sollwertausgang einer Leistungssteuerung, die beispielsweise in das Bauteil 18 integriert ist, und dem Sollwerteingang des Hochfrequenzgenerators 17 geschaltet ist.

Die Software-Steuerung bzw. der digitale Rampengenerator empfiehlt sich insbesondere dann, wenn die Leistung des Hochfrequenzgenerators mit einem digitalen Befehl, beispielsweise über eine serielle Schnittstelle (RS232) angefordert wird, wie dies bei vielen bekannten Ätzanlagen der Fall ist. In diesem Fall muß durch eine Folge digitaler Befehle die Leistung des Hochfrequenzgenerators 17 in kleinen Schritten, ausgehend von einem Startwert, bis zum gewünschten Zielwert hochgefahren werden.

Die analoge Variante über den analogen Rampengenerator 19 zwischen dem Ausgang der Anlagensteuerung und einem Generatorsollwerteingang empfiehlt sich insbesondere dann, wenn der Hochfrequenzgenerator 17 mit einem Analogsignal, beispielsweise einem Pegelwert zwischen 0 V und 10 V, gesteuert wird.

Die einfachste Version eines analogen Rampengenerators 19 ist ein in Figur 2 dargestellter erster RC-Kreis 23 mit entsprechend der gewünschten Anstiegsgeschwindigkeit der Leistung des Hochfrequenzgenerators 17 angepaßter Zeitkonstante. Dieser erste RC-Kreis weist sowohl in Aufwärts- als auch in Abwärtsrichtung eine Verzögerungswirkung auf.

Soll der analoge Rampengenerator 19 nur in Aufwärtsrichtung wirksam sein, d.h. nur bei Leistungssteigerung, eine gewünschte Abnahme der Leistung des Hochfrequenzgenerators 17 aber sofort d.h. instantan erfolgen, verwendet man bevorzugt einen zweiten, mit einer Diode versehenen RC-Kreis 24, wie er in Figur 3 dargestellt ist.

Sind für das Hochregeln und das Herunterregeln der Leistung des Hochfrequenzgenerators 17 zwei frei wählbare Verzögerungswerte wünschenswert, setzt man bevorzugt einen dritten, mit zwei unterschiedlichen Widerständen und jeweils zugeordneten Dioden versehenen RC-Kreis 25 ein, wie er in Figur 4 dargestellt ist.

Die in den Figuren 2 bis 4 erläuterten Schaltungsbeispiele für Rampengeneratoren sind jedoch Stand der Technik und sollen nur die Ausführung der erfindungsgemäßen Varianten erläutern und dem Fachmann Anhaltspunkte geben, wie daraus die gewünschte Rampenfunktion abgeleitet werden kann. Insbesondere ist in den Figuren 2 bis 4 die Durchlaßspannung der Dioden von ca. 0,6 Volt nicht berücksichtigt.

Insgesamt liegt die typische Zeitdauer der Erhöhung der Hochfrequenzleistung beim Wechsel von einem Depositionsschritt zu einem Ätzschritt im erläuterten Beispiel bei 0,2 sec bis 5 sec, insbesondere 0,5 sec bis 3 sec. Die Zeitdauer der Erniedrigung der Hochfrequenzleistung beim Wechsel von einem Ätzschritt zu einem Depositions- oder Polymerisationsschritt ist dagegen üblicherweise deutlich kürzer und liegt zwischen 0 sec bis 2 sec, insbesondere 0 sec bis 0,5 sec.

### Bezugszeichenliste

- 5: Plasmaätzanlage
- 10: Substrat
- 11: Substratelektrode
- 12: Substratspannungsgenerator
- 13: Plasmaquelle
- 14: Plasma
- 15: Reaktor
- 16: Impedanztransformator
- 17: Hochfrequenzgenerator
- 18: Bauteil
- 19: Rampengenerator

- 23: erster RC-Kreis
- 24: zweiter RC-Kreis
- 25: dritter RC-Kreis

## Patentansprüche

1. Vorrichtung zum Ätzen eines Substrates (10), insbesondere eines strukturierten Siliziumkörpers, mittels eines Plasmas (14), mit einer Plasmaquelle (13) zum Generieren eines hochfrequenten elektromagnetischen Wechselfeldes, an die mit einem Hochfrequenzgenerator (17) eine Hochfrequenzleistung anlegbar ist, und einem Reaktor (15) zum Erzeugen des Plasmas (14) aus reaktiven Teilchen durch Einwirken des hochfrequenten elektromagnetischen Wechselfeldes auf ein Reaktivgas oder ein Reaktivgasgemisch, wobei ein erstes Mittel vorgesehen ist, das eine periodische Änderung der an der Plasmaquelle (13) anliegenden Hochfrequenzleistung bewirkt, wobei das erste Mittel ein Bauteil zur Leistungssteuerung des Hochfrequenzgenerators ist, in das über eine Software ein digitaler Rampengenerator einprogrammiert ist, oder wobei das Mittel ein Bauteil (18) zur Leistungssteuerung des Hochfrequenzgenerators ist, das einen analogen Rampengenerator (19) aufweist.

2. Vorrichtung nach Anspruch 1, **dadurch gekennzeichnet, dass** der analoge Rampengenerator (19) einen insbesondere mit mindestens einer Diode versehenen RC-Kreis (23, 24, 25) aufweist.

3. Vorrichtung nach Anspruch 1 und/oder 2, **dadurch gekennzeichnet, dass** ein zweites Mittel vorgesehen ist, das zumindest zeitweilig während der periodischen Änderung der an der Plasmaquelle (13) anliegenden Hochfrequenzleistung eine Anpassung der Ausgangsimpedanz des Hochfrequenzgenerators (17) an die jeweilige, als Funktion der Hochfrequenzleistung sich ändernde Impedanz der Plasmaquelle (13) bewirkt.

4. Vorrichtung nach Anspruch 3, **dadurch gekennzeichnet, dass** die Anpassung der Ausgangsimpedanz fortwährend oder schrittweise erfolgt und automatisiert ist, und dass die anliegende Hochfrequenzleistung zwischen 400 W und 5000 W liegt.

5. Vorrichtung nach Anspruch 3, **dadurch gekennzeichnet, dass** das zweite Mittel ein Impedanztransformator (16) ist.

6. Verfahren zum anisotropen Ätzen eines Substrates (10) mit einer Vorrichtung nach mindestens einem der vorangehenden Ansprüche, wobei der anisotrope Ätzvorgang in separaten, jeweils alternierend aufeinanderfolgenden Ätz- und Polymerisationsschritten durchgeführt wird, und wobei während der Polymerisationsschritte auf durch eine Ätzmaske definierte lateralen Strukturen ein Polymer aufgebracht wird, das während der nachfolgenden Ätzschritte jeweils wieder abgetragen wird, wobei während der Ätzschritte zumindest zeitweise eine jeweils höhere Hochfrequenzleistung an der Plasmaquelle (13) angelegt wird als während der Depositionsschritte, **dadurch gekennzeichnet, dass** die Erhöhung der Hochfrequenzleistung beim Wechsel von den Depositionsschritten zu den Ätzschritten und/oder die Erniedrigung der Hochfrequenzleistung beim Wechsel von den Ätzschritten zu den Depositionsschritten schrittweise oder kontinuierlich erfolgt.

7. Verfahren nach Anspruch 6, **dadurch gekennzeichnet, dass** zumindest die Erhöhung der Hochfrequenzleistung derart erfolgt, dass in dieser Zeit zumindest zeitweilig über das zweite Mittel, insbesondere den Impedanztransformator (16), eine zumindest näherungsweise, insbesondere fortwährende oder schrittweise und automatisierte Impedanzanpassung des Hochfrequenzgenerators (17) an die Plasmaimpedanz erfolgt.

8. Verfahren nach Anspruch 6, **dadurch gekennzeichnet, dass** die Zeitdauer der Erhöhung der Hochfrequenzleistung beim Wechsel von einem Depositionsschritt zu einem Ätzschritt 0,2 sec bis 5 sec, insbesondere 0,5 sec bis 3 sec beträgt, und/oder dass die Zeitdauer der Erniedrigung der Hochfrequenzleistung beim Wechsel von einem Ätzschritt zu einem Depositionsschritt 0 sec bis 2 sec, insbesondere 0 sec bis 0,5 sec, beträgt.

9. Verfahren nach einem der Ansprüche 6 bis 8, **dadurch gekennzeichnet, dass** während der Ätzschritte zumindest zeitweilig eine Hochfrequenzleistung von 800 Watt bis 5000 Watt, insbesondere von 2000 Watt bis 4000 Watt, und während der Depositionsschritte zumindest zeitweise eine Hochfrequenzleistung von 400 Watt bis 1500 Watt, insbesondere von 500 Watt bis 1000 Watt, an der Plasmaquelle (13) angelegt wird.

10. Vorrichtung zum Zünden eines Plasmas (14) und zum Hochregeln oder Pulsen einer Plasmaleistung, mit einer Plasmaquelle (13), insbesondere einer induktiven Plasmaquelle, zum Generieren eines hochfrequenten elektromagnetischen Wechselfeldes, an die mit einem Hochfrequenzgenerator (17) eine Hochfrequenzleistung anlegbar ist, einem Reaktor (15) zum Erzeugen des Plasmas (14) aus reaktiven Teilchen durch Einwirken des hochfrequenten elektromagnetischen Wechselfeldes auf ein Reaktivgas oder ein Reaktivgasgemisch, wobei ein Mittel vorgesehen ist, über das, ausgehend von einem Startwert, eine kontinuierliche oder schrittweise Erhöhung der an der Plasmaquelle (13) anliegenden Hochfrequenzleistung auf einen Zielwert einstellbar ist, wobei das Mittel ein Bauteil zur Leistungssteuerung des Hochfrequenzgenerators (17) ist, in das über eine Software ein digitaler Rampengenerator einprogrammiert ist, oder dass das Mittel ein Bauteil (18) zur Leistungssteuerung des Hochfrequenzgenerators (17) ist, das einen analogen Rampengenerator (19) aufweist.

11. Vorrichtung nach Anspruch 10, **dadurch gekennzeichnet, dass** ein Impedanztransformator (16) vorgesehen ist, der während der Erhöhung der Hochfrequenzleistung zumindest zeitweilig eine insbesondere fortwährende oder schrittweise und automatisierte Anpassung der Ausgangsimpedanz des Hochfrequenzgenerators (17) an die jeweilige, als Funktion der Hochfrequenzleistung sich ändernde Impedanz der Plasmaquelle (13) bewirkt.

12. Verfahren zum Zünden eines Plasmas (14) und zum Hochregeln einer Plasmaleistung mit einer Vorrichtung nach Anspruch 10 und/oder 11, **dadurch gekennzeichnet, dass** die kontinuierliche oder schrittweise Erhöhung der Hochfrequenzleistung von dem Startwert zu dem Zielwert begleitet wird von einer zumindest zeitweiligen, über das zweite Mittel, insbesondere den Impedanztransformator (16), erfolgenden Impedanzanpassung des Hochfrequenzgenerators (17) an die jeweilige Plasmaimpedanz.

13. Verfahren nach Anspruch 12, **dadurch gekennzeichnet, dass** der Startwert 0 bis 400 Watt und der Zielwert 800 Watt bis 5000 Watt beträgt, und dass die Erhöhung des Startwertes zu dem Zielwert über eine Zeitdauer von 0,2 sec bis 5 sec, insbesondere 0,5 sec bis 2 sec, erfolgt.

14. Verfahren nach Anspruch 12 oder 13, **dadurch gekennzeichnet, dass** das Zünden und Hochregeln des Plasmas (14) zeitlich gepulst erfolgt.

## Claims

1. Device for etching a substrate (10), in particular a structured silicon body, by means of a plasma (14), comprising a plasma source (13) for generating a high-frequency alternating electromagnetic field, to which plasma source a high-frequency power can be applied by means of a high-frequency generator (17), and comprising a reactor (15) for generating the plasma (14) from reactive particles by the action of the high-frequency alternating electromagnetic field on a reactive gas or a reactive gas mixture, wherein a first means is provided, which brings about a periodic change in the high-frequency power present at the plasma source (13), wherein the first means is a component for the power control of the high-frequency generator into which a digital ramp generator is programmed by means of software, or wherein the means is a component (18) for the power control of the high-frequency generator which has an analogue ramp generator (19).

2. Device according to Claim 1, **characterized in that** the analogue ramp generator (19) has an RC circuit (23, 24, 25) provided with at least one diode, in particular.

3. Device according to Claim 1 and/or 2, **characterized in that** a second means is provided, which brings about at least temporarily during the periodic change in the high-frequency power present at the plasma source (13) a matching of the output impedance of the high-frequency generator (17) to the respective impedance of the plasma source (13) that changes as a function of the high-frequency power.

4. Device according to Claim 3, **characterized in that** the matching of the output impedance is effected continuously or in stepwise fashion and is automated, and **in that** the high-frequency power present is between 400 W and 5000 W.

5. Device according to Claim 3, **characterized in that** the second means is an impedance transformer (16).

6. Method for anisotropically etching a substrate (10) by means of a device according to at least one of the preceding claims, wherein the anisotropic etching process is carried out in separate etching and polymerization steps that succeed one another alternately in each case, and wherein, during the polymerization steps, a polymer is applied to lateral structures defined by an etching mask, said polymer being removed again in each case during the subsequent etching steps, wherein, at least at times, a respectively higher high-frequency power is applied to the plasma source (13) during the etching steps than during the deposition steps, **characterized in that** the increase in the high-frequency power when changing from the deposition steps to the etching steps and/or the decrease in the high-frequency power when changing from the etching steps to the deposition steps take(s) place in stepwise fashion or continuously.

7. Method according to Claim 6, **characterized in that** at least the increase in the high-frequency power is effected in such a way that an at least approximate, in particular continuous or stepwise and automated impedance matching of the high-frequency generator (17) to the plasma impedance is effected in this time at least temporarily via the second means, in particular the impedance transformer (16).

8. Method according to Claim 6, **characterized in that** the time duration of the increase in the high-frequency power when changing from a deposition step to an etching step is 0.2 sec to 5 sec, in particular 0.5 sec to 3 sec, and/or **in that** the time duration of the decrease in the high-frequency power when changing from an etching step to a deposition step is 0 sec to 2 sec, in particular 0 sec to 0.5 sec.

9. Method according to any of Claims 6 to 8, **characterized in that** a high-frequency power of 800 watts to 5000 watts, in particular of 2000 watts to 4000 watts, is applied to the plasma source (13) at least temporarily during the etching steps and a high-frequency power of 400 watts to 1500 watts, in particular of 500 watts to 1000 watts, is applied to the plasma source (13) at least at times during the deposition steps.

10. Device for igniting a plasma (14) and for regulating upwards or pulsing a plasma power, comprising a plasma source (13), in particular an inductive plasma source, for generating a high-frequency alternating electromagnetic field, to which plasma source a high-frequency power can be applied by means of a high-frequency generator (17), comprising a reactor (15) for generating the plasma (14) from reactive particles by the action of the high-frequency alternating electromagnetic field on a reactive gas or a reactive gas mixture, wherein a means is provided by which, proceeding from a start value, a continuous or stepwise increase in the high-frequency power present at the plasma source (13) to a target value can be set, wherein the means is a component for the power control of the high-frequency generator (17) into which a digital ramp generator is programmed by means of software, or wherein the means is a component (18) for the power control of the high-frequency generator (17) which has an analogue ramp generator (19).

11. Device according to Claim 10, **characterized in that** an impedance transformer (16) is provided, which, during the increase in the high-frequency power, at least temporarily, brings about an in particular continuous or stepwise and automated matching of the output impedance of the high-frequency generator (17) to the respective impedance of the plasma source (13) that changes as a function of the high-frequency power.

12. Method for igniting a plasma (14), and for regulating upwards a plasma power by means of a device according to Claim 10 and/or 11, **characterized in that** the continuous or stepwise increase in the high-frequency power from the start value to the target value is accompanied by an at least temporary impedance matching of the high-frequency generator (17) to the respective plasma impedance, said impedance matching being effected via the second means, in particular the impedance transformer (16).

13. Method according to Claim 12, **characterized in that** the start value is 0 to 400 watts and the target value is 800 watts to 5000 watts, and **in that** the increase in the start value to the target value is effected over a time duration of 0.2 sec to 5 sec, in particular 0.5 sec to 2 sec.

14. Method according to Claim 12 or 13, **characterized in that** the plasma (14) is ignited and regulated upwards in temporally pulsed fashion.

## Revendications

1. Dispositif pour graver un substrat (10), en particulier un corps en silicium structuré, au moyen d'un plasma (14), présentant
une source de plasma (13) qui crée un champ électromagnétique alternatif à haute fréquence sur lequel une puissance à haute fréquence peut être appliquée à l'aide d'un générateur (17) à haute fréquence et
un réacteur (15) de formation du plasma (14) à partir de particules réactives par action du champ électromagnétique alternatif à haute fréquence sur un gaz réactif ou un mélange de gaz réactifs,
un premier moyen étant prévu pour entraîner une modification périodique de la puissance à haute fréquence appliquée sur la source (13) de plasma, le premier moyen étant un composant de commande de puissance du générateur à haute fréquence dans lequel un générateur numérique de pente est programmé par l'intermédiaire d'un logiciel ou le moyen étant un composant (18) de commande de la puissance du générateur à haute fréquence qui présente un générateur analogique (19) de pente.

2. Dispositif selon la revendication 1, **caractérisé en ce que** le générateur analogique (19) de pente présente un circuit RC (23, 24, 25) doté en particulier d'au moins une diode.

3. Dispositif selon les revendications 1 et/ou 2, **caractérisé en ce qu'**il présente un deuxième moyen qui, au moins pendant une partie du temps au cours de la modification périodique de la puissance à haute fréquence appliquée sur la source (13) de plasma, a pour effet une adaptation de l'impédance de sortie du générateur (17) à haute fréquence à l'impédance de la source (13) de plasma qui varie en fonction de la puissance à haute fréquence.

4. Dispositif selon la revendication 3, **caractérisé en ce que** l'adaptation de l'impédance de sortie s'effectue en continu ou par pas et est automatisée et **en ce que** la puissance à haute fréquence appliquée est située entre 400 W et 5 000 W.

5. Dispositif selon la revendication 3, **caractérisé en ce que** le deuxième moyen est un transformateur d'impédance (16).

6. Procédé de gravure anisotrope d'un substrat (10) à l'aide d'un dispositif selon au moins l'une des revendications précédentes, dans lequel l'opération de gravure anisotrope est exécutée en des étapes distinctes, successives et alternées de gravure et de polymérisation, et dans lequel, pendant les étapes de polymérisation, un polymère qui est de nouveau enlevé pendant l'étape de gravure qui suit est appliqué sur des structures latérales définies par un masque de gravure, tandis que pendant l'étape de gravure, au moins une partie du temps, la puissance à haute fréquence appliquée sur la source (13) de plasma est plus élevée que pendant l'étape de dépôt,
**caractérisé en ce que**
l'augmentation de la puissance à haute fréquence lors du passage des étapes de dépôt aux étapes de gravure et/ou la diminution de la puissance à haute fréquence lors du passage des étapes de gravure aux étapes de dépôt s'effectuent par pas ou en continu.

7. Procédé selon la revendication 6, **caractérisé en ce qu'**au moins l'augmentation de la puissance à haute fréquence s'effectue de telle sorte que pendant cette durée, une adaptation d'impédance, en particulier continue ou par pas et automatisée, du générateur (17) à haute fréquence à l'impédance du plasma a lieu au moins approximativement une partie du temps par l'intermédiaire du deuxième moyen et en particulier du transformateur d'impédance (16).

8. Procédé selon la revendication 6, **caractérisé en ce que** la durée de l'augmentation de la puissance à haute fréquence lors du passage d'une étape de dépôt à une étape de gravure est de 0,2 s à 5 s et en particulier de 0,5 s à 3 s et/ou **en ce que** la durée de la diminution de la puissance à haute fréquence lors du passage d'une étape de gravure à une étape de dépôt est de 0 s à 2 s et en particulier de 0 s à 0,5 s.

9. Procédé selon l'une des revendications 6 à 8, **caractérisé en ce que** pendant l'étape de gravure, une puissance à haute fréquence de 800 Watt à 5 000 Watt et en particulier de 2 000 Watt à 4 000 Watt est appliquée au moins une partie du temps et **en ce que** pendant l'étape de dépôt, une puissance à haute fréquence de 400 Watt à 1 500 Watt et en particulier de 500 Watt à 1 000 Watt est appliquée au moins une partie du temps sur la source (13) de plasma.

10. Dispositif d'allumage d'un plasma (14) et de régulation vers le haut ou de pulsation d'une puissance plasma, présentant
une source (13) de plasma, en particulier une source inductive de plasma, qui crée un champ électromagnétique alternatif à haute fréquence sur lequel une puissance à haute fréquence peut être appliquée à l'aide d'un générateur (17) à haute fréquence,
un réacteur (15) qui crée le plasma (14) à partir de particules réactives par action du champ électromagnétique alternatif à haute fréquence sur un gaz réactif ou un mélange de gaz réactifs
un moyen étant prévu par lequel, partant d'une valeur initiale, une augmentation continue ou par pas de la puissance à haute fréquence appliquée sur la source (13) de plasma permet d'amener cette puissance à une valeur cible, le moyen étant un composant de commande de puissance du générateur (17) à haute fréquence dans lequel un générateur numérique de pente peut être programmé à l'aide d'un logiciel ou le moyen étant un composant (18) de commande de la puissance du générateur (17) à haute fréquence qui présente un générateur analogique (19) de pente.

11. Dispositif selon la revendication 10, **caractérisé en ce qu'**il présente un transformateur d'impédance (16) qui, pendant l'augmentation de la puissance à haute fréquence, a pour effet au moins une partie du temps une adaptation de l'impédance de sortie du générateur (17) à haute fréquence, en particulier continue ou par pas et automatisée, à l'impédance de la source (13) de plasma qui varie en fonction de la puissance à haute fréquence.

12. Procédé d'allumage d'un plasma (14) et de régulation de la puissance plasma vers le haut à l'aide d'un dispositif selon les revendications 10 et/ou 11, **caractérisé en ce que** l'augmentation continue ou par pas de la puissance à haute fréquence est accompagnée depuis la valeur initiale jusqu'à la valeur cible par une adaptation à l'impédance du plasma de l'impédance du générateur (17) à haute fréquence qui est réalisée au moins une partie du temps par le deuxième moyen, en particulier par le transformateur d'impédance (16).

13. Procédé selon la revendication 12, **caractérisé en ce que** la valeur initiale représente de 0 à 400 Watt et la valeur cible de 800 Watt à 5 000 Watt et **en ce que** l'augmentation de la valeur initiale jusqu'à la valeur cible s'effectue en une durée de 0,2 s à 5 s et en particulier de 0,5 s à 2 s.

14. Procédé selon la revendication 12 ou 13, **caractérisé en ce que** l'allumage et la régulation du plasma (14) vers le haut s'effectuent de manière pulsée dans le temps.
